Europäisches Patentamt

European Patent Office

Office européen des brevets

(19)

(11) Veröffentlichungsnummer: **0 000 123**
**B1**

(12) **EUROPÄISCHE PATENTSCHRIFT**

(21) Anmeldenummer: **78100110.2**

(22) Anmeldetag: **07.06.78**

(51) Int. Cl.³: **C 30 B 19/00,**
**H 01 L 21/208**

(54) Verfahren zum Abscheiden einkristalliner Schichten nach der Flüssigphasen-Schiebeepitaxie.

(30) Priorität: **05.07.77 DE 2730358**

(43) Veröffentlichungstag der Anmeldung:
**10.01.79 Patentblatt 79/1**

(45) Bekanntmachung des Hinweises auf die Patenterteilung:
**25.02.81 Patentblatt 81/8**

(84) Benannte Vertragsstaaten:
**BE FR GB SE**

(56) Entgegenhaltungen:
**US - A - 3 899 371**
**US - A - 3 933 538**
**US - E - 28 140**

**INSTRUMENTS AND EXPERIMENTAL TECHNI-**
**QUES, vol. 19, nr. 4, Punkt 2, 1976**
**S. G. ZHILENIS et al "Cassette for batch growth of**
**layers by the liquid-epitaxy method", Seiten 1221**
**bis 1222**

(73) Patentinhaber: **SIEMENS AKTIENGESELLSCHAFT**
**Berlin und München**
**Postfach 22 02 61**
**D-8000 München 22 (DE)**

(72) Erfinder: **Weyrich, Claus**
**Untertaxetweg 14**
**D-8035 Gauting (DE)**
(72) Erfinder: **Hosp, Werner**
**Mühlbauerstrasse 14**
**D-8000 München 80 (DE)**

Courier Press, Leamington Spa, England.

Verfahren zum Abscheiden einkristalliner Schichten nach der Flüssigphasen-Schiebeepitaxie.

Die Erfindung betrifft ein Verfahren zum Abscheiden einkristalliner Schichten nach der Flüssigphasen-Schiebeepitaxie, wie es im Oberbegriff des Patentanspruches 1 näher angegeben ist.

Zur Herstellung bestimmter Halbleiterbauelemente, z.B. zur Herstellung von Lumineszenzdioden oder Laserdioden, ist es notwendig, auf einem Halbleiterkristall eine oder mehrere Schichten aus Halbleitermaterial epitaxial abzuscheiden. Insbesondere zur Herstellung von Halbleiterbauelementen aus intermetallischen III-V-Verbindungen und deren Mischkristalle wird dazu die Technik der Flüssigphasen-Schiebeepitaxie angewendet. Bei dieser Methode wird mit Hilfe eines Schiebers eine Schmelze, die das abzuscheidende Material enthält, auf die Oberfläche eines Substrates aufgeschoben und sodann durch leichtes Abkühlen der Schmelze Material auf der Substratoberfläche einkristallin abgeschieden. Sobald mit dem Abscheiden die vorgesehene Schichtdicke der einkristallinen Schicht erreicht ist, wird mit Hilfe des Schiebers die restliche Schmelze von der Substratoberfläche bzw. der aufgewachsenen Epitaxieschicht abgeschoben. Ein solches Schiebeepitaxie-Verfahren sowie eine Vorrichtung zur Durchführung dieses Verfahrens sind beispielsweise in der US-Patentschrift 3 753 801 beschrieben. Zur Herstellung von kohärent und inkohärent strahlenden Doppelheterostruktur-Dioden, z.B. einer (Ga, Al) As-GaAs-Diode, sowie auch bei Mikrowellen-Bauelementen mit Heterostruktur ist es notwendig, aufeinander mehrere Schichten epitaxial abzuscheiden. Diese Schichten unterscheiden sich dabei in ihrer Zusammensetzung, z.B. bei einer GaAs-(GaAl)As-Schichtfolge, im Aluminiumgehalt.

Aus der US-Re 28 140 ist bekannt, je eine Epitaxieschicht auf aufeinanderfolgende Substrate aufwachsen zu lassen. Es ist dort ein einziger Vorratsbehälter 10—12 vorhanden, aus dem mit einem ersten Schieber 13 in eine Öffnung 18 portionsweise Schmelze entnommen und dann durch Verschieben auf eine Substratscheibe aufgebracht wird. Soll eine weitere Scheibe beschichtet werden, ist ein weiterer Schieber 14 vorzusehen, mit dem die Substratscheiben und die Portionsöffnung 18 des ersten Schiebers gegeneinander und gegenüber dem einen Vorratsbehälter verschoben werden müssen. Für die erneute Abscheidung ist vorherige Wiedererwärmung auf die ursprüngliche Ausgangstemperatur vorgesehen. Zusätzlich ist in der US-Re 28 140 noch lediglich erwähnt, mehrere Substrate in Tandemweise zu beschichten. Auch ist die Möglichkeit, mehrere Schichten aufeinander abzuscheiden, erwähnt, wozu zusätzliche Vorratsbehälter und zusätzliche Portionsöffnungen in einem verlängerten ersten Schieber vorzusehen sind. Die Substratscheibe befindet sich wohl wieder im zweiten Schieber.

Schichtfolgen, wie sie beispielsweise für Doppelheterostruktur-Laserdioden oder -Lumineszenzdioden benötigt werden, werden üblicherweise mit Schiebeapparaturen hergestellt, bei denen sich in einem Graphit-"Boot" in geeignet ausgebildeten Vertiefungen die Substratscheiben befinden, und bei denen ein beweglicher Schieber vorhanden ist, der mehrere Kammern für die verschiedenen Schmelzen unterschiedlicher Zusammensetzung aufweist. Die Substratscheiben sind dabei hintereinander oder konzentrisch im gleichen Abstand angeordnet, und die Kammern des Schiebers sind ebenfalls hintereinander oder konzentrisch mit dem entsprechenden Abstand angeordnet. Durch Weiterschieben bzw. Drehen des Schiebers werden die Schmelzen nacheinander über den jeweiligen Substratkristall geschoben, wobei jedes Mal durch Abkühlen der Schmelze um einen gewissen Temperaturbetrag auf der Substratscheibe eine einkristalline Schicht aufwächst. Die Dicke der aufgewachsenen Schicht wird durch die Größe der Temperaturabsenkung der Schmelze und durch die Dicke der Schmelze über dem Substrat, und, sofern nicht die der Temperaturabsenkung entsprechende Menge gelöster Substanz zur Gänze auf dem Substrat abgeschieden wird, auch durch die Abkühlgeschwindigkeit der Schmelze festgelegt. Wenn auf einem Substrat sehr dünne Schichten abgeschieden werden sollen, so müssen zum Abscheiden Schmelzen verwendet werden, die mit dem Material des Substrates gesättigt sind, damit beim Aufschieben der Schmelze nicht eine unkontrollierte Auflösung des Substratkristalles an seiner Oberfläche und als deren Folge ein unkontrolliertes Schichtwachstum auftritt. Eine exakte Sättigung der Schmelzen wird am einfachsten dadurch bewerkstelligt, daß die jeweils verwendete Schmelze durch genügend langes Verweilen auf einem Vorsubstrat in ein Lösungsgleichgewicht gebracht wird, bevor sie auf das eigentliche Substrat aufgeschoben wird. Bei tatsächlich ausgeführten Apparaturen, in denen mehrere Substratscheiben gleichzeitig beschichtet werden, ist für jede abzuscheidende Schicht einer jeden Substratscheibe eine gesonderte Kammer in dem Schieber vorgesehen worden. Zur Herstellung einer 4-Schichtstruktur, bei der zur Abscheidung der einzelnen Schichten jeweils unterschiedliche Abkühlintervalle angewendet werden, ist ein Schieber eingesetzt worden, dessen Kammerzahl 4 mal so groß ist wie die Zahl der zu beschichtenden Substratscheiben. Dies hat bereits bei einer kleinen Anzahl von Substratscheiben zu einer sehr komplizierten Konstruktion des Schiebers bzw. des "Bootes" geführt. Ferner konnte die hohe Anzahl von Kammern bei der Beschickung dieser "Boote" leicht zu Fehlern führen. Bei der Verwendung von Vorsubstraten ist bei diesem Verfahren darüber hinaus auch die doppelte Anzahl von Substratscheiben erforderlich, was die Kosten des Verfahrens zusätzlich erhöht.

Aufgabe der Erfindung ist es, ein Verfahren zum Abscheiden einkristalliner Schichten nach der Flüssigphasen-Schiebeepitaxie anzugeben, mit dem es möglich ist, mehrere Substratscheiben gleichzeitig mit einer Vielschicht-Struktur zu versehen, ohne daß derartige Vorsubstrate notwendig sind und das es erlaubt, die Zahl der für die aufzuschiebenden Schmelzen vorgesehenen Kammern des Schiebers zu vermindern.

Diese Aufgabe wird bei einem wie im Oberbegriff des Patentanspruches 1 angegebenen Verfahren erfindungsgemäß nach der im kennzeichnenden Teil des Patentanspruches 1 angegebenen Weise gelöst.

Vorteilhafte Ausgestaltungen der Erfindung sind in den Unteransprüchen angegeben.

Der Vorteil des erfindungsgemäßen Verfahrens besteht einmal darin, daß die einzelnen Schichten auf den jeweiligen Substratscheiben jeweils aus derselben Schmelze abgeschieden werden, und daß weiterhin die Temperaturabsenkung für die einzelnen Schmelzen jeweils um den gleichen Betrag erfolgt. Zur Steuerung der Dicke der jeweils abgeschiedenen Schicht wird die Dicke der über der Substratscheibe befindlichen Schmelze entsprechend variiert.

Die jeweilige Schmelze, aus der heraus die betreffende Schicht einkristallin abgeschieden werden soll, verbleibt solange auf dem Substratkristall, bis sie sich mit diesem im Gleichgewicht befindet. Die zu beschichtenden Substratscheiben sind in der für die Durchführung des erfindungsgemäßen Verfahrens verwendeten Apparatur hintereinander im gleichen Abstand wie der Abstand der für die Schmelzen vorgesehenen Kammern des Schiebers angeordnet. Die Substratscheiben bzw. die für die Schmelzen vorgesehenen Kammern können linear oder auch auf konzentrischen Kreisen angeordnet sein.

Zum Abscheiden der ersten einkristallinen Schichten wird eine erste Schmelze auf ein erstes Substrat aufgeschoben. Die erste Schmelze kann gegebenenfalls auch über ein Vorsubstrat in das Lösungsgleichgewicht gebracht worden sein. Nachdem die erste Schmelze auf das erste Substrat aufgeschoben worden ist, wird die Anordnung um ein bestimmtes Temperaturintervall T, das beispielsweise etwa 1°C beträgt, abgekühlt. Dabei scheidet sich Material, das in der Schmelze gelöst ist, auf der Substratoberfläche epitaktisch ab. Die Schmelze wird solange auf dem Substrat belassen, bis die Schmelze das bei dieser neuen Temperatur herrschende Lösungsgleichgewicht erreicht hat, d.h. bis die Schmelze für die Abscheidung erschöpft ist.

Man kann davon ausgehen, daß das Wachstum aus der Schmelze heraus durch die Diffusion des in der Schmelze gelösten Stoffes bestimmt wird, beispielsweise bei der Abscheidung von GaAs durch die Diffusion des As in der Ga-Schmelze. In diesem Falle ist die Mindestverweilzeit der Schmelze auf dem Substrat nach Abschluß der Abkühlung durch die Gleichung.

$$t_{min} = \frac{W^2_{max}}{D}$$

gegeben, wobei $W_{max}$ die größte Dicke der zum Abscheiden verwendeten Schmelze und D der Diffusionskoeffizient des gelösten Materials in der Schmelze ist. Voraussetzung für die Notwendigkeit dieser Mindestverweilzeit ist, daß die Gleichung $\alpha \cdot \Delta T \ll t_{min}$ erfüllt ist, wobei $\alpha$ die reziproke Abkühlungsgeschwindigkeit, $\Delta T$ das Abkühlungsintervall ist. Gilt statt dieser letzten Gleichung die Gleichung $\alpha \cdot \Delta T > t_{min}$, so kann nach erfolgter Abkühlung die Mindestverweildauer jedoch entsprechend niedriger gehalten werden. Wird die reziproke Abkühlungsgeschwindigkeit der Schmelze hinreich groß gehalten, so könnte eine Haltezeit der Schmelze auf dem Substrat ohne gleichzeitige Temperaturabsenkung sogar gänzlich entfallen. Dadurch, daß die Schmelzen, die zum Abscheiden der jeweiligen Schicht auf die Substrate aufgeschoben werden, unterschiedlich dick gehalten werden, können trotz des für alle Schmelzen gleichen Abkühlintervalles dennoch verschieden dicke Schichten auf den jeweiligen Substratscheiben aufgewachsen werden, da unter den angegebenen Bedingungen die Dicke der jeweils abgeschiedenen Schicht der Dicke der über der jeweiligen Substratscheibe befindlichen Schmelze proportional ist. Beispielsweise muß bei einem Abkühlintervall $\Delta T = 1°C$ und einer Ausgangstemperatur von beispielsweise 800°C für eine Abscheidung von GaAs aus einer Ga-As-Schmelze die Dicke der Schmelze etwa 1 mm betragen, um eine 1 $\mu$m dicke GaAs-Schicht aufzuwachsen, wobei die Haltezeit nach der Gleichung

$$t_{min} = \frac{W^2_{max}}{D}$$

mit D ungefähr gleich $5 \cdot 10^{-5} cm^2 sec^{-1}$ etwa 200 sec betragen muß. Nach dieser Haltezeit wird sodann die erste Schmelze durch Weiterschieben des Schiebers auf des zweite Substrat geschoben; gleichzeitig wird dann die zweite Schmelze auf das erste Substrat zur Abscheidung der zweiten Schicht geschoben. Die Anordnung wird sodann wieder um den gleichen Temperaturbetrag, in dem angegebenen Beispiel also um 1°C, abgekühlt. Danach wird sodann die erste Schmelze auf die dritte Substratscheibe, die zweite Schmelze auf die zweite Substratscheibe, und die dritte Schmelze auf die erste Substratscheibe aufgeschoben, und dann die gesamte Anordnung wiederum um 1°C abgekühlt. Diese Verfahrensschritte werden entsprechend der Zahl der Substrate und der abzuscheidenden Schichten fortgeführt. Sollen beispielsweise zehn Substratscheiben mit einer 4-Schichtstruktur versehen werden, so sind also vier Kammern für die Schmelzen vorzusehen, und es sind insgesamt vierzehn Schiebeschritte erforderlich. Daraus ergibt sich eine Gesamtabkühlung von 14°C, wenn bei jedem einzelnen Schiebeschritt die Abkühlung um 1°C erfolgt. Innerhalb eines Temperaturintervalles von 14°C können die Temperaturabhängigkeiten der Löslichkeit bzw. der Verteilungskoeffizienten der Komponenten und Dotierstoffe in der Schmelze vernachlässigt werden, so daß für die Substratscheiben die abgeschiedenen Schichten gleiche Schichtdicken aufweisen.

Im folgenden wird die Erfindung anhand eines in den Figuren dargestellten Ausführungsbeispiels beschrieben und näher erläutert.

Fig. 1 zeigt schematisch die für die Durchführung des erfindungsgemäßen Verfahrens verwendete Apparatur,

Fig. 2 zeigt schematisch, wie die Temperatur der gesamten Anordnung zur Abscheidung einzelner Schichten auf den jeweiligen Substratscheiben abgesenkt werden wird.

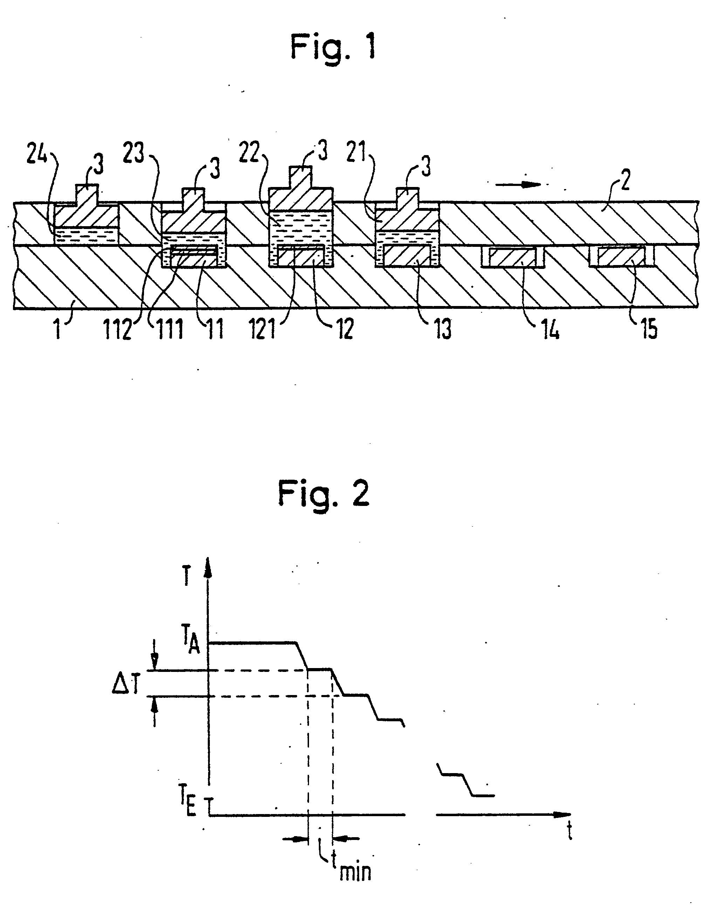

Fig. 1 zeigt schematisch den Verfahrensgang zur Herstellung einer 4-Schichtstruktur auf GaAs-Substraten. In einem "Boot" 1, das beispielsweise aus Graphit besteht, befinden sich die Substratscheiben 11, 12, 13, 14 und 15. Auf diesem Boot 1 ist ein Schieber 2 aufgesetzt, der vier Kammern enthält, in denen die Schmelzen 21, 22, 23 und 24 enthalten sind. Die Dicke der jeweiligen Schmelzen über den Substraten wird durch die Menge der eingefüllten Schmelze eingestellt. Mit Stempeln 3 wird verhindert, daß bei kleinen Schmelzdicken sich die Schmelze aufgrund Oberflächenspannung zu einem Tropfen zusammenzieht. Zum Abscheiden einer 4-Schichtstruktur auf den Substraten wird der Schieber zunächst in eine Position gebracht, bei der sich über dem Substrat 11 die Schmelze 21 befindet. Dabei wird auf dem Substrat 11 eine Schicht 111 abgeschieden. Sodann wird der Schieber in die nächste Position gebracht, so daß die Schmelze 21 sich über dem Substrat 12 befindet. Die Temperatur der Anordnung wird jetzt wiederum um einen Betrag von etwa 1°C abgesenkt. Dabei scheidet sich auf dem Substrat 12 eine Schicht 121 einkristallin ab, aus der jetzt über dem Substrat 11 befindlichen Schmelze 22 scheidet sich eine Schicht 112 auf dem Substrat 11 ab. Im nächsten Verfahrensschritt wird der Schieber 2 wiederum in Pfeilrichtung weitergeschoben, so daß die Schmelze 21 sich jetzt über dem Substrat 13 befindet. Dieser Zustand ist in Fig. 1 dargestellt. Die Temperatur der Anordnung wird wiederum um den Betrag ΔT = 1°C abgesenkt. Dabei scheidet sich auf dem Substrat 13 dann die erste epitaxiale Schicht, auf dem Substrat 12 die zweite und auf dem Substrat 11 die dritte epitaxiale Schicht ab. Danach wird der Schieber 2 wiederum um eine Stellung weitergeschoben, so daß die Schmelze 21 nun über dem Substrat 14, die Schmelze 24 über dem Substrat 11 vorhanden ist. In entsprechender Weise wird fortgefahren, bis alle Substrate mit einer 4-Schichtstruktur überzogen sind.

Fig. 2 zeigt den Temperaturverlauf der gesamten Anordnung. Die Anfangstemperatur $T_A$ beträgt beispielsweise 800°C. Entsprechend der vorhandenen Anzahl von Substraten sowie der Zahl der abzuscheidenden Schichten erfolgt eine schrittweise Temperaturabsenkung jeweils um einen Betrag ΔT, beispielsweise um 1°C. Die Endtemperatur $T_E$ liegt bei einem Verfahren, bei dem zehn Substratscheiben mit einer 4-Schichtstruktur überzogen werden, beispielsweise 14°C tiefer als die Anfangstemperatur.

**Patentansprüche**

1. Verfahren zum Abscheiden von einkristallinen Schichtten auf Substraten nach der Flüssigphasen-Schiebeepitaxie, bei dem gleichzeitig auf mehreren Substraten verschiedene einkristalline Schichten aufeinander abgeschieden werden, indem mittels eines Schiebers Schmelzen auf die Substrate aufgeschoben und nach dem Abscheiden der jeweiligen Schicht durch Weiterschieben des Schiebers wieder entfernt werden, wobei ein Schieber verwendet wird, der mehrere in gleichen Abständen angeordnete Kammern aufweist, in welchen sich die Schmelzen des abzuscheidenden Materials befinden, wobei das Abscheiden der einzelnen Schichten mittels Absenken der Temperatur der auf dem jeweiligen Substrat befindlichen Schmelze erfolgt, dadurch gekennzeichnet, daß die Substrate in regelmäßigen Abständen angeordnet sind, wobei jeder Abstand dem Abstand der Kammern des Schiebers gleich ist, und daß bei jedem Abscheidevorgang die Temperatur aller sich jeweils auf einem Substrat befindlichen Schmelzen um den gleichen Betrag gesenkt wird, daß zur Abscheidung einkristalliner Schichten von vorgegebener Dicke die Dicke der auf dem betreffenden Substrat befindlichen Schmelze auf einen der abzuscheidenden Schichtdicke entsprechenden Wert gehalten wird und daß nach Abschluß der Temperaturabsenkung bis zum Abschieben der Schmelze eine Mindestverweilzeit $t_{min}$ eingehalten wird, deren Größe nach der Formel

$$t_{min} = \frac{W^2_{max}}{D} \quad \text{für } \alpha \cdot \Delta T << t_{min} \text{ und}$$

$$t_{min} < \frac{W^2_{max}}{D} \quad \text{für } \alpha \cdot \Delta T > t_{min}$$

bestimmt ist, worin $W_{max}$ die größte Dicke der in der Anordnung vorhandenen Schmelzen, D der Diffusionskoeffizient des in der Schmelze gelösten Materials, $\alpha$ die reziproke Abkühlgeschwindigkeit und $\Delta T$ der Betrag der Temperaturabsenkung des einzelnen Abkühlungsschrittes sind.

2. Verfahren nach Anspruch 1 zur Herstellung einkristalliner Schichten auf III-V-Verbindungs-Halbleitern, dadurch gekennzeichnet, daß als Schmelze eine Schmelze der III-Komponente gewählt wird, in der Material der V-Komponente gelöst ist.

3. Anwendung eines Verfahrens nach einem der Ansprüche 1 oder 2 zur Herstellung von Heterostruktur-Halbleiterkristallen.

**Revendications**

1. Procédé pour déposer des couches monocristallines sur des substrats selon l'épitaxie à déplacement de phases liquides, dans lequel on dépose simultanément, les unes sur les autres, différentes couches monocristallines sur plusieurs substrats, par déplacement à l'aide d'un tiroir de distribution de masses en fusion sur les substrats au moyen d'un tiroir et écartement des masses en fusion après le dépôt de la couche concernée, par la poursuite du déplacement du tiroir, du type dans lequel on utilise un tiroir qui possède plusieurs chambres disposées à des distances identiques et dans lesquelles sont situées, les masses en fusion de matériau à déposer, le dépôt des différentes couches étant effectué au moyen d'un abaissement de la température de la masse en fusion située sur le substrat, caractérisé par le fait que les substrats sont disposés à des distances régulières qui sont égales à celles des chambres du tiroir, que pour chaque processus de dépôt la température de toutes les masses en fusion situées respectivement sur un substrat est abaissée de la même valeur, que pour le dépôt de couches monocristallines possédant une épaisseur prédéterminée, l'épaisseur de la masse en fusion située au-dessus du substrat considéré est maintenue à une valeur correspondant à l'épaisseur de couche à déposer, et qu'à la fin de l'abaissement de la température et jusqu'au déplacement de la masse en fusion, on maintient un temps de séjour minimal $t_{min}$ dont la valeur est déterminée selon les relations

$$t_{min} = \frac{W^2_{max}}{D} \text{ pour } \alpha \cdot \Delta T << t_{min} \quad \text{et}$$

$$t_{min} < \frac{W^2_{max}}{D} \text{ pour } \alpha \cdot \Delta T > t_{min}$$

dans lesquelles $W_{max}$ représente l'épaisseur maximale des masses en fusion présentes dans le dispositif, D est le coefficient de diffusion du matériau dessous dans la masse en fusion, $\alpha$ est l'inverse de la vitesse de refroidissement et $\Delta T$ est la valeur de la diminution de température de la phase individuelle de refroidissement.

2. Procédé suivant la revendication 1 pour fabriquer des couches monocristallines sur des semi-conducteurs formés de composés d'éléments des groupes III et V, caractérisé par le fait que l'on choisit comme masse en fusion une masse en fusion des composants du groupe III, dans laquelle est dissous un matériau des composés du groupe v.

3. Application du procédé selon l'une des revendications 1 ou 2 pour fabriquer des cristaux semi-conducteurs à structure hétérogène.

**Claims**

1. Process for the deposition of monocrystalline layers on substrates by liquid phase slide epitaxy, in which different monocrystalline layers are deposited on one another at the same time on a plurality of substrates by applying melts to the substrates by means of a slide and removing them by further movement of the slide after the deposition of the particular layer, wherein a slide is used which possesses a plurality of equidistantly arranged chambers which contain the melts of the materials to be deposited, and wherein the deposition of the individual layers is effected by lowering the temperature of the melt which is present on the particular substrate, characterised in that the substrates are uniformly arranged, each distance being equal to the distance of the chambers of the slide, that in each depositing step, the temperature of all the melts which are present on a substrate in each case is lowered by the same amount, that for the deposition of monocrystalline layers of predetermined thickness the thickness of the melt which is present on the particular substrate is kept at a value which corresponds to the layer thickness to be deposited, and that after the termination of the lowering of the temperature until the removal of the melt, a minimum duration $t_{min}$ is observed whose magnitude is determined in accordance with the formulae

$$t_{min} = \frac{W^2_{max}}{D} \text{ for } \alpha \cdot \Delta T << t_{min} \text{ and}$$

$$t_{min} < \frac{W^2_{max}}{D} \text{ for } \alpha \cdot \Delta T > t_{min}$$

wherein $W_{max}$ is the greatest thickness of the melts in the arrangement, D is the diffusion coefficient of the material dissolved in the melt, $\alpha$ is the reciprocal rate of cooling and $\Delta T$ the amount of the lowering of temperature of the individual cooling step.

2. Process as claimed in Claim 1 for the production of monocrystalline layers on III-V-compound semiconductors, characterised in that a melt of the III-component is selected as the melt in which material of the V-component is dissolved.

3. Use of a process as claimed in one of the Claims 1 or 2 for the production of heterostructure-semiconductor crystals.

# Fig. 1

# Fig. 2